# EUROPEAN PATENT APPLICATION

(11) **EP 1 686 628 A2**
(43) Date of publication of application: **02.08.2006**
(21) Application number: 05257576.8
(22) Date of filing: 09.12.2005
(51) Int. Cl.: H01L 31/0203, H01L 27/146, H01L 23/48, H01L 31/0224

(54) **Chip scale image sensor module and fabrication method of the same**

(30) Priority: 01.02.2005 KR 2005008990
(71) Applicant: Samsung Electro-Mechanics Co., Ltd., Suwon, Kyungki-do (KR)
(72) Inventor: Ryu, Jin Mun, Yongin Kyungki-do (KR); Song, Moon Koog, Youngtong-ku Suwon Kyungki-do (KR)
(74) Representative: Powell, Timothy John

(57) **Abstract**

The present invention provides a chip scale image sensor module and the fabrication method of the same which includes an optical filter removing specific wavelength from the light into the image sensor and a glass layer attached to the optical filter to protect a coating layer, forming pad electrodes on the backside thereof. The invention also includes an image sensor attached to the pad electrodes with redistribution pads formed from the pad electrodes in the backside, and solder balls provided on the backside of the image sensor. The invention reduces the size of the module, screens and uses good quality image sensor modules, saving the manufacturing costs, and having advantage in mass production.

## Description

### CLAIM OF PRIORITY

This application claims the benefit of Korean Patent Application No. 2005-8990 filed on February 1, 2005, in the Korean Intellectual Property Office, the disclosure of which is incorporated herein by reference.

### BACKGROUND OF THE INVENTION

### Field of the Invention

The present invention relates to a chip scale image sensor module used in digital optical devices and the fabrication method of the same. More particularly, the present invention relates to a chip scale image sensor module and the fabrication method of the same which minimizes the size of an image sensor referred to as a complementary metal oxide semiconductor (CMOS) or a charge coupled device (CCD), capable of screening and using good quality image sensors to fabricate good quality packages, thereby saving the manufacturing costs and having an advantage in mass production.

### Description of the Related Art

Recently, there is an increasing demand for a compact, high-definition image sensor module as its use has been increasing in portable or home video cameras, digital cameras as well as mobile phone cameras. The needs for a small-sized, compact-package image sensor module are on the rise not only in terms of greater number of pixels for good color reproductibility and delicate expression, but also in terms of its application in the mobile phones.

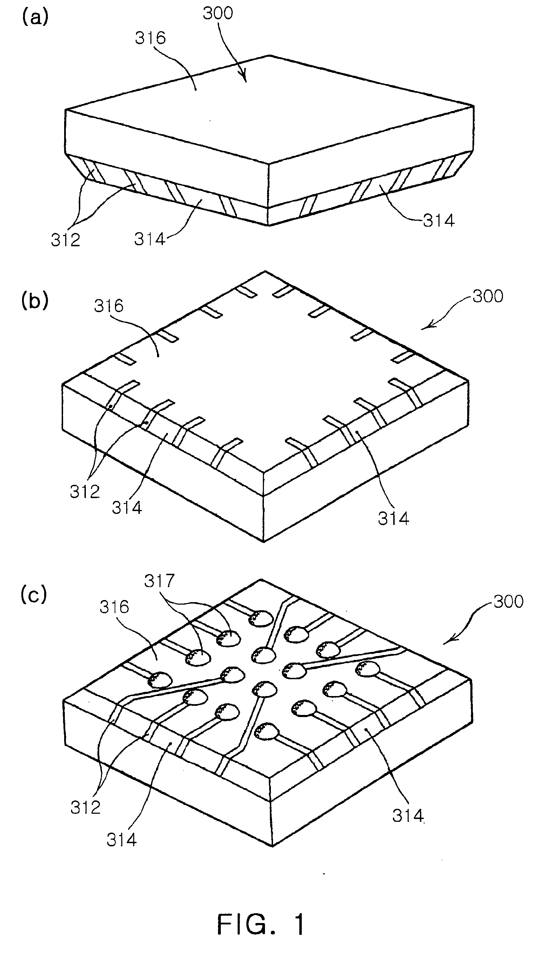

FIG. 1 illustrates a front side of an image sensor module 300 according to the prior art. The image sensor module 300 is of a basic structure which can be applied to a camera module of a mobile phone in the following three forms: Chip on Board (COB) using gold wire bonding technique, Chip on FPC (COF) using Anisotropic Conductive Film (ACF) or Non-conductive Paste (NCP), and Chip Scale Package (CSP). Among these, the CSP has been drawing most attention, appropriate for small size and mass production.

There is a variety of fabrication methods of a conventional image sensor module. Among these, the most widely used method is the Shell-OPC by Shellcase Ltd.

FIG. 1 illustrates the chip scale image sensor module 300 produced by the conventional Shell-OPC, which is published in PCT application WO 99/40624. This conventional chip scale image sensor module 300 having a thin, dense structure, is well-protected from outside environment, mechanically strengthened, and plated with a plurality of electrical contacts 312 along edge surfaces 314.

The contacts 312 extend over the entire edge surfaces 314 onto a planar surface 316 of the image sensor module. With this arrangement of the contacts, the image sensor module 300 and the edge can be attached by the planar surface to the circuit board. The above described conventional image sensor module 300 includes fusible bumps 317 disposed at the end of each contact 312. These fusible bumps 317 are arranged in an array.

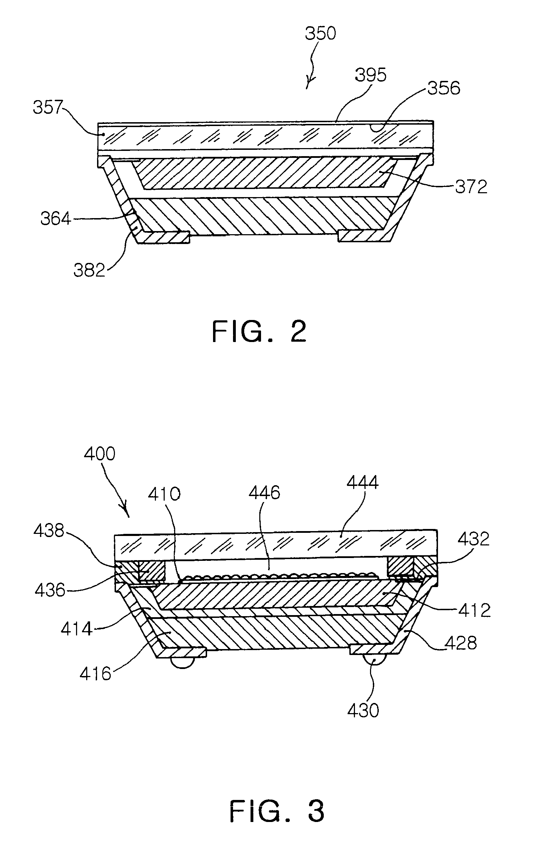

FIG. 2 illustrates another conventional chip scale image sensor module 350 similar to the above description, which is published in PCT application WO 99/40624. This conventional chip scale image sensor module 350 has a light emitter and/or light receiver, with the upper and lower surfaces formed of electric insulation and mechanical protective material. At least one of the upper and lower surfaces includes an integrated circuit die 372 having a protective film 357 transmitting light, and pads are mounted on electrically insulated edge surfaces 364.

Moreover, the conventional chip scale image sensor module 350 has a structure in which a plurality of electric contacts 382 are plated along the edge surfaces 364, and screening filter and/or reflection prevention coating film 395 is formed on the outer contact surface 356 of a transparent protective film 357.

FIG. 3 illustrates another conventional chip scale image sensor module 400, which is published in PCT application WO 01/43181. This conventional chip scale image sensor module 400 has a micro-lens array 410 formed on a crystalline silicon substrate. Underlying the silicon substrate 412, a package layer 416 formed typically of glass is sealed with epoxy 414. Along the edges of the package layer 416, electric contacts 428, which typically form bumps 430 thereon, are formed. Also, conductive pads 432 connect the silicon substrate 412 with the electric contacts 428.

In this conventional chip scale image sensor module 400, typically a glass layer 444 and spacer elements 436 related thereto are sealed by an adhesive such as epoxy 438 in the upper part of the silicon substrate 412 to form a space 446 between the micro-lens array 410 and the glass layer 444. The package layer 444 is preferably transparent.

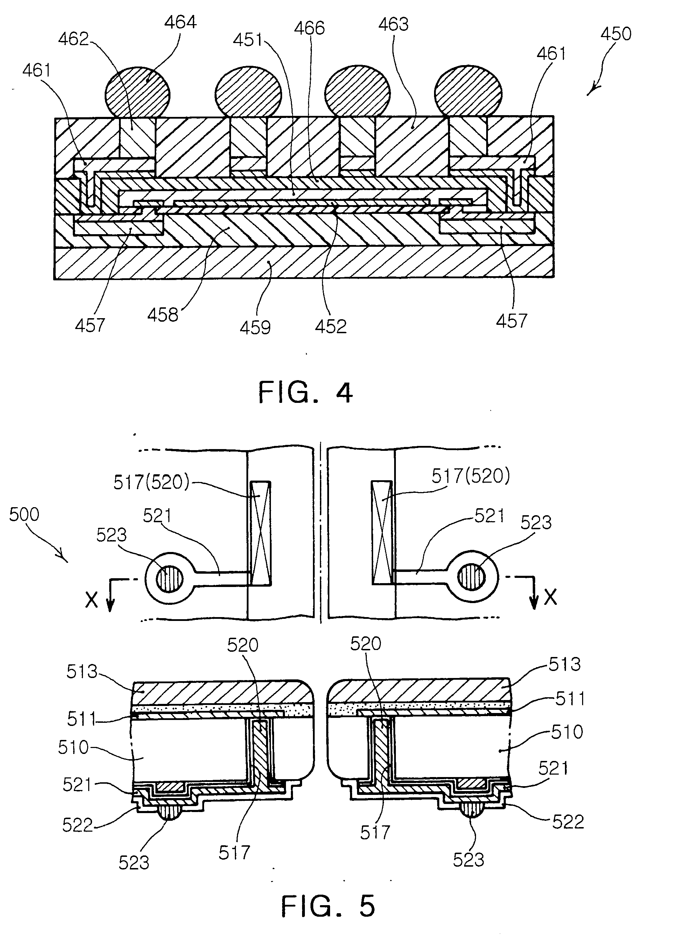

In the meantime, FIG. 4 illustrates a chip scale image sensor module 450 of a different type from the above described ones, published in Japanese Patent Application No. 2002-274807. This conventional chip scale image sensor module 450 has a transparent adhesive layer 458 attached to a glass substrate 459 corresponding to a plurality of image sensor modules. On the top of the transparent adhesive layer 458, silicon substrates 451 having photoelectric device regions 452 are attached at a regular interval. In such a conventional structure, connecting wires 457 are connected to connection pads 453 of the silicon substrate 451 near the bottom surface of the silicon substrate 451.

Then, after forming insulating films 456, rerouting pads 461, columnar electrodes 462, packaging film 463 and welding balls 464, it is diced between the silicon substrates 451 to obtain a plurality of chip scale image sensor modules 450 having photoelectric regions 452. However, this type of conventional image sensor modules 450 is complicated in its structure, difficult to fabricate.

On the other hand, FIG. 5 illustrates another conventional chip scale image sensor module 500, which is published in Japanese Laid-open Patent Application No. 2004-153260. This conventional chip scale image sensor module 500 has pad electrode 511 formed on the semiconductor tip 510, and supporting substrate 513 attached to the surface of the semiconductor tip 510. Also, vias 517 extend from the bottom surface of the semiconductor tip 510 to reach the surface of the pad electrode 511, and inside each via 517, columnar terminal 520 is formed, connected to the pad electrode 511.

The columnar terminal 520 forms rerouting pad layer 521, with solder masks 522 coated thereon, and bumps 523 thereon electrically connected to the rerouting pad layer 521.

The prior art described above is aimed to provide a chip scale image sensor module with highly reliable Ball Grid Array (BGA), whose unique structure is capable of preventing disconnection or deterioration of step coverage.

However, the conventional image sensor modules are faced with a problem when the yield of the image sensors is particularly low. The problem occurs due to the fact that defective image sensors are also packaged in the manufacturing process, resulting in the packaging costs of good quality image sensors burdened with the packaging costs of defective image sensors, which in turn, increases the costs of production.

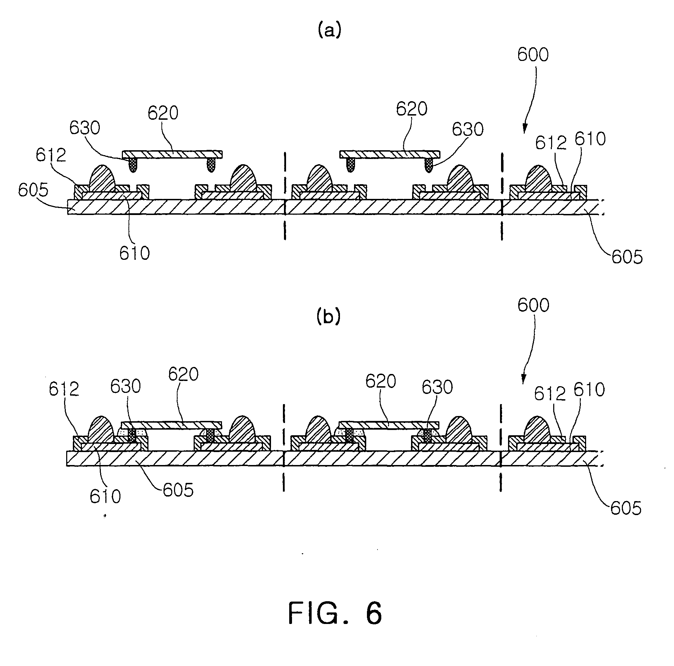

FIG. 6 (a) and (b) illustrate another conventional chip scale image sensor module 600, which uses glass for glass substrate 605 having metal wires 610 and insulation films 612 protecting the metal wires 610 thereon. Also, image sensor chips 620 are electrically connected to the glass substrate 605 using solder ball joints 630.

Further, outer solder balls 640 are formed on the metal wires 610 to be electrically connected to the outside PCB substrate (not shown).

Therefore, the electric signals from the image sensor chips 620 are transmitted to the outside PCB substrate via the metal wires 610 and the outer solder balls 640 on the glass substrate 605.

However, this type of conventional chip scale image sensor modules is complicated in its structure, difficult to fabricate.

The above described conventional chip scale image sensor modules receive light whose wavelength not only includes infrared ray region, visible ray region, ultraviolet ray region, and other regions, but also includes a visible ray region of the wavelength in which humans see and perceive objects.

Therefore, each of the camera modules installed with the above described conventional image sensor modules has an optical filter. If the optical filter is an IR filter, it can lower transmission rate of the infrared rays.

As the light of the infrared ray region contains heat, the optical filter lowers the transmission rate of the infrared rays while increasing reflection rate to protect the image sensor receiving the light, and also increasing the transmission rate of the visible ray region perceived by humans.

In the prior art, the optical filter is coated on a rectangular glass and cut into individual units which are then attached to each image sensor module. Therefore, in the prior art, the installation of the optical filter was conducted separately from the installation of the image sensor module, requiring so many steps in the manufacturing process.

### SUMMARY OF THE INVENTION

The present invention has been made to solve the foregoing problems of the prior art and it is therefore an object of the present invention to provide a chip scale image sensor module and the fabrication method of the same which enables packaging only the good quality image sensors, tremendously increasing the yield of the image sensor module, thereby saving the manufacturing costs and having an advantage in mass production.

It is another object of the invention to provide a chip scale image sensor module and the fabrication method of the same in which an optical filter is integrally provided in the manufacturing process without needing to attach a separate optical filter to the camera module, achieving improved productivity due to the improved manufacturing processes.

It is further another object of the present invention to provide a chip scale image sensor module and the fabrication method of the same which can be conveniently mounted via the conventional reflow method when being installed on the PCB, improving productivity of the assembly of the camera module.

According to an aspect of the invention for realizing the object, the invention provides a chip scale image sensor module used in digital devices including: an optical filter removing specific wavelength from the light incident onto the image sensor; a glass layer attached to the optical filter to protect the coating layer, with pad electrodes formed on the backside thereof; an image sensor attached to the pad electrodes of the glass layer, with redistribution pads formed from the pad electrodes to the backside thereof; and solder balls provided on the backside of the image sensor, electrically connected to the pad electrodes.

Furthermore, the present invention provides a fabrication method of a chip scale image sensor module used in digital devices, the method including steps of: forming a glass wafer by attaching a wafer-type glass layer to a wafer-type optical filter removing specific wavelength from the light incident onto the image sensor; forming pad electrodes on the glass layer of the glass wafer; bonding the pad electrodes with bumps to attach a plurality of image sensors on the glass wafer; forming redistribution pads connected to the pad electrodes of the glass wafer in the backside of each image sensor; providing solder balls on each redistribution pad of the image sensor; and dicing the glass wafer into a plurality of image sensor modules.

### BRIEF DESCRIPTION OF THE DRAWINGS

The above and other objects, features and other advantages of the present invention will be more clearly understood from the following detailed description taken in conjunction with the accompanying drawings, in which:

FIG. 1 is a block diagram illustrating a chip scale image sensor module according to the prior art in which: (a) is a front side view, (b) is a rear side view, and (c) is a perspective view with solder balls;

FIG. 2 is a longitudinal sectional view illustrating another structure of the chip scale image sensor module according to the prior art;

FIG. 3 is a longitudinal sectional view illustrating another structure of the chip scale image sensor module according to the prior art;

FIG. 4 is a longitudinal sectional view illustrating another chip scale image sensor module having solder balls according to the prior art;

FIG. 5 is a longitudinal sectional view illustrating another chip scale sensor module having vias;

FIG. 6 (a) and (b) are longitudinal sectional views illustrating another chip scale image sensor module according to the prior art;

FIG. 7 is a sectional view illustrating a chip scale image sensor module according to the present invention;

FIG. 8 is a view illustrating the process of forming a glass wafer by binding the glass layer with the optical filter in the fabrication method of the chip scale image sensor module according to the present invention;

FIG. 9 is a view illustrating the process of forming metal layer on the glass wafer in the fabrication method of the chip scale image sensor module according to the present invention;

FIG. 10 is a view illustrating the process of forming pad electrodes on the metal layer of the glass wafer in the fabrication method of the chip scale image sensor module according to the present invention;

FIG. 11 is a view illustrating the process of attaching the image sensor to the pad electrodes on the glass wafer in the fabrication method of the chip scale image sensor module according to the present invention;

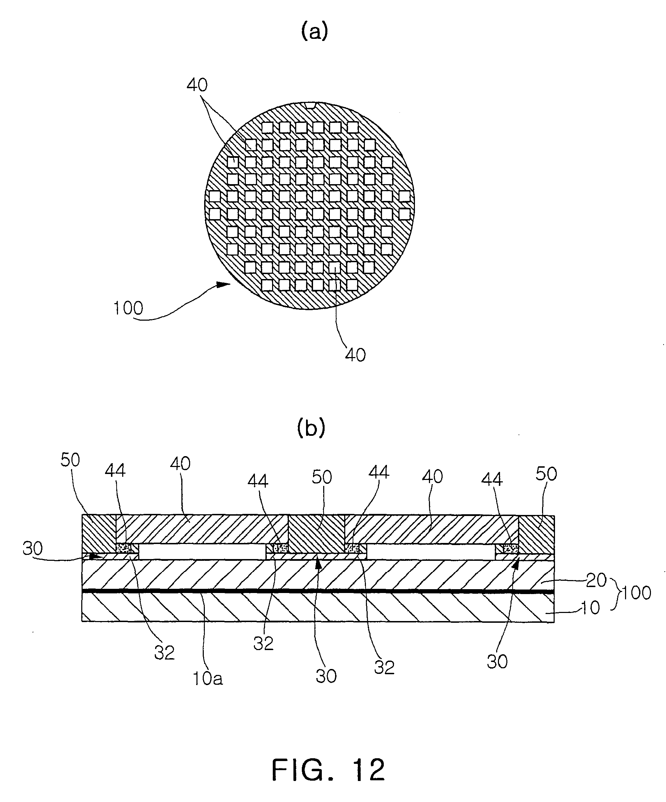

FIG. 12 is a view illustrating the process of forming resin layers between the image sensors on the glass wafer in the fabrication method of the chip scale image sensor module according to the present invention;

FIG. 13 is a view illustrating the process of forming vias in the resin layers on the glass wafer in the fabrication method of the chip scale image sensor module according to the present invention;

FIG. 14 is a view illustrating the process of forming redistribution pads through the vias in the resin layers in the fabrication method of the chip scale image sensor module according to the present invention;

FIG. 15 is a view illustrating the process of providing solder balls on the redistribution pads in the fabrication method of the chip scale image sensor module according to the present invention; and

FIG. 16 is a view illustrating the process of dicing the glass wafer obtained from the fabrication method of the scale chip image sensor module into a plurality of chip scale image sensor modules, according to the present invention.

### DETAILED DESCRIPTION OF THE PREFERRED EMBODIMENT

Preferred embodiments of the present invention will now be described in detail with reference to the accompanying drawings.

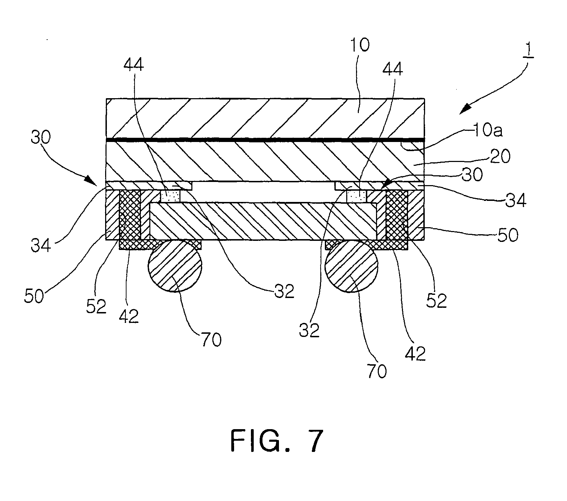

As shown in FIG. 7, the image sensor module 1 according to the present invention integrally includes an optical filter 10 which removes specific wavelength from the light incident onto the image sensor.

The optical filter 10 may be, but not limited to, a general IR filter.

The optical filter 10 may have its coating layer 10a on both upper and lower surfaces, but preferably, the coating layer 10a is formed to face the glass layer 20.

The image sensor module 1 of the present invention has a glass layer 20 attached to the optical filter 10 to protect the coating layer 10a, with pad electrodes 30 formed on the backside thereof.

The glass layer 20 may be formed by adhesively attaching the optical filter 10 with a transparent adhesive or by conducting a fusion bonding of H and OH groups using the moisture in the air. The latter fusion bonding guarantees 100% of transmission rate of light since the glass layer 20 and the optical filter 10 can be bonded with nothing in between. Therefore, superior transmission characteristics of light can be obtained with fusion boding to using a transparent adhesive. Here, it is preferable that the coating layer 10a of the optical filter is formed between the optical filter 10 and the glass layer 20.

The glass layer 20 has pad electrodes 30 formed on its outer surface thereof. The seed metal of the pad electrodes 30 may include TiW, Al, Cu and Ni when using PVD sputtering, and also may include Pd when using electroless plating. A main metal part of the pad electrodes 30 on the seed metal is generally Au/Ni, Au on Ni, and also includes plating of Cu, Sn and alloys of Sn.

As for the plating method, PVD sputtering may be adopted, as with the seed metal, but electric plating is more appropriate in terms of yield and mass production. In addition, the pad electrodes 30 are obtained from patterning the metal coated on the glass layer 20. The resultant pad electrodes 30 includes flip-chip pads which are flip-chip bonded to the image sensor 40 described hereinbelow, and expansion pads 34 for redistribution.

Moreover, the chip scale image sensor module 1 according to the present invention includes an image sensor 40 which is attached to the pad electrodes 30 of the glass layer 20, with redistribution pads 42 formed from the pad electrodes 30 to the backside of the image sensor 40. The flip-chip bonded image sensors 40 are only the ones with good quality. In general, the flip-chip image sensor 40 is provided with Au bumps 44, and bonded with Anisotropic Conductive Film (ACF) . The ACF may be substituted with Anisotropic Conductive Paste (ACP), Non-Conductive Paste (NCP) and Non-Conductive Film (NCF). In addition, the bumps 44 of the image sensor 40 may include solder ball bumps rather than Au bumps.

The chip scale image sensor module 1 according to the present invention includes redistribution pads 42 formed in the backside of the image sensor 40, electrically connected to the expansion pads 34 of the pad electrodes 30 formed on the glass layer 20. Further, the image sensor module 1 includes insular resin layer 50 formed between the expansion pads 34 and the redistribution pads 42, and vias 52 perforated through the resin layer 50. The vias 52 are plated with metal to have the expansion pads 34 electrically connected to the redistribution pads 42.

In addition, the present invention includes solder balls 70 provided on the backside of the image sensor 40, and electrically connected to the pad electrodes 30.

With the above described structure, the chip scale image sensor module 1 according to the present invention can solve the foregoing problems with conventional methods. That is, in the conventional method, when the image sensor is completed into a wafer form, a low yield of image sensor wafers including a great number of defective image sensors is manufactured to constitute the image sensor modules, resulting in defective image sensor modules. As a result, the defective image sensor modules are discarded and the costs incurred thereby are entirely burdened on the manufacturing costs of the good quality image sensor modules.

Therefore, in the prior art, the manufacturing costs of good quality image sensors are increased inevitably, whereas the present invention is able to screen and use only the good quality image sensors, solving the above mentioned problem.

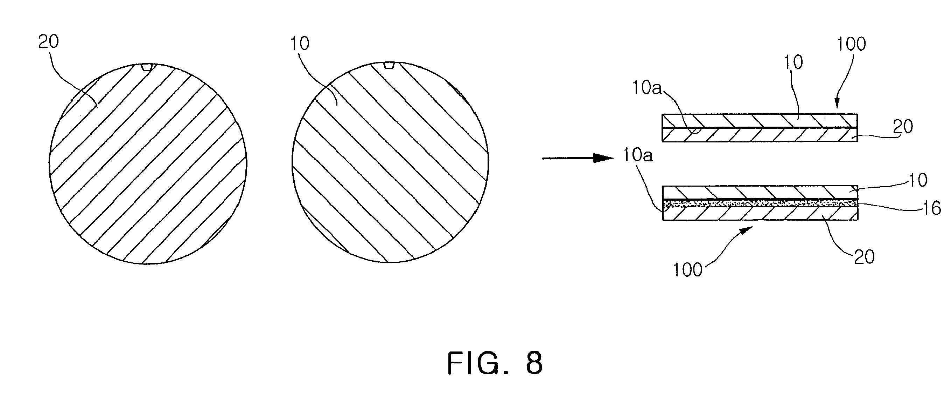

As shown in FIG. 8, the fabrication method of the chip scale image sensor module starts with the step of attaching the wafer-type glass layer 20 to the wafer-type optical filter 10 which removes specific wavelength from the light incident onto the image sensor 40 to form a glass wafer 100.

More specifically, in the above step, glass is processed into a wafer-type to form a glass layer 20 while an optical filter coating layer 10a is formed on the other wafer-type glass to form a wafer-type optical filter 10, and then the two are bonded to form a glass wafer 100.

In the conventional method, a coating layer is formed on a rectangular glass, cut into individual optical filters, which are then attached to the camera modules.

However, unlike the conventional method, the present invention provides the optical filter 10 in a wafer form, producing a glass wafer 100. Then, the resultant glass wafer 100 is packaged with the fabrication steps at a wafer level, diced into individual parts having an image sensor 40 to obtain a plurality of chip scale image sensor modules 1.

The step of forming the glass wafer 100 includes attaching the wafer-type glass layer 20 and the wafer-type optical filter 10, which may be conducted using a transparent adhesive 16, as shown in FIG. 8, and also via fusion bonding of H and OH groups using the moisture in the air. The latter fusion bonding allows bonding with nothing in between the glass layer 20 and the optical filter 10, guaranteeing 100% of light transmission rate. Therefore, better light transmission characteristics can be obtained with fusion bonding than with the transparent adhesive 16. Through the above process, the glass layer 20 and the wafer-type optical filter 10 are attached to each other to form a glass wafer 100.

In addition, the fabrication method of the chip scale image sensor module includes forming pad electrodes 30 on the glass layer 20 of the glass wafer 100.

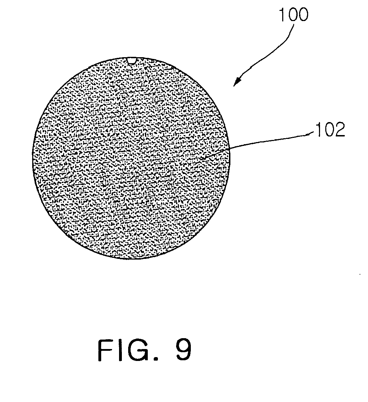

This step includes covering the glass wafer 100 with metal to form a pattern thereon. As described above, and shown in FIG. 9, the step of forming metal 102 on the glass layer 20 of the glass wafer 100 includes covering the glass layer 20 with seed metal and then covering with main metal. The seed metal may include TiW, Al, Cu, and Ni when using sputtering of PVD. Pd may be used in electroless plating. A main metal part on the seed metal generally includes Au/Ni, Au on Ni, and also may include plating of Cu, Sn and alloys of Sn. The plating method may adopt PVD sputtering, as with seed metal, but electric plating is more appropriate in terms of mass production.

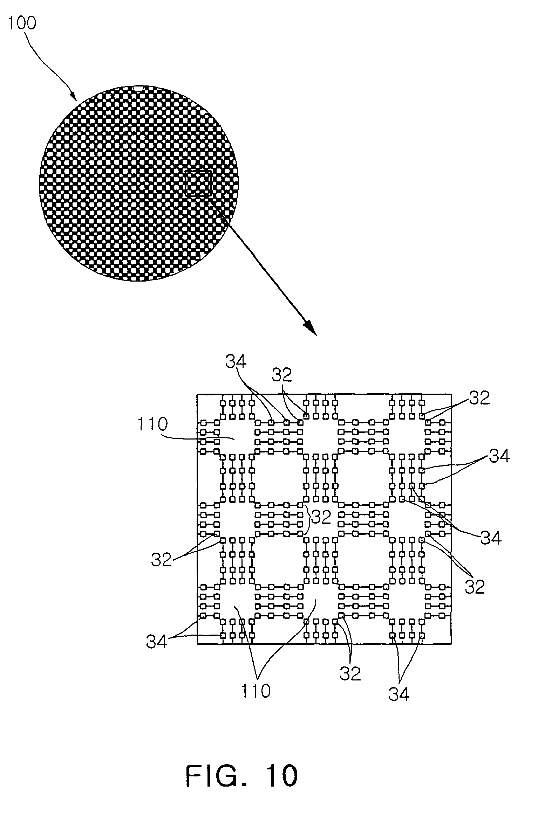

Moreover, the step of forming pad electrodes 30 on the glass layer 20 of the glass wafer 100 includes patterning the metal coated on the glass layer 20 of the glass wafer 100. As shown in FIG. 10, this patterning step includes forming a pattern on the metal 102 formed on the glass layer 20 to form flip-chip pads which is to be flip-chip bonded with the image sensor 40 so as to mount the image sensor 40. This patterning step further includes forming expansion pads 34 for forming redistribution pads 42 described hereinbelow.

As shown in FIG. 10, on the glass layer 20 of the glass wafer 100, image sensor regions 110 are formed, with flip-chip pads 32 and expansion pads 34 surrounding the image sensor regions 110.

In addition, the fabrication method of the chip scale image sensor module according to the present invention includes bonding the bumps 44 with the pad electrodes 30 to attach a plurality of image sensors 40 on the glass wafer 100.

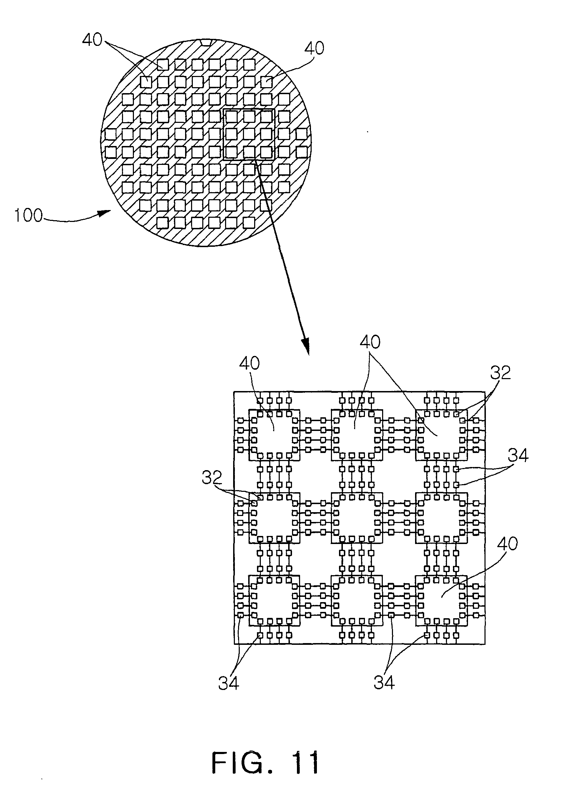

This step involves flip-chip bonding only the good quality image sensors to the glass wafer 100. As shown in FIG. 11, this step bonds the bumps 44 formed on the good quality image sensors 40 with the flip-chip pads 32 of the glass wafer 100 formed in advance. In general, the flip-chip image sensor 40 is provided with Au bumps 44, and bonded with ACF.

However, the present invention is not limited to the above, and the ACF may be substituted with ACP, NCP and NCF. In addition, the bumps 44 of the image sensor 40 may be substituted with solder ball bumps.

As described above, through the above steps, the present invention is able to remove defective image sensors 40 while screening and mounting only good quality image sensors 40, obtaining good quality chip scale image sensor modules 1.

Therefore, lower costs of manufacturing good quality chip scale image sensor module 1 can be expected.

In addition, the fabrication method of the chip scale image sensor module according to the present invention includes forming redistribution pads 42 on the backside of the image sensor 40 connected to the pad electrodes 30 of the glass wafer 100.

As described above, this step of forming redistribution pads 42 includes filling with resin layer 50 the space between the image sensors 40 flip-chip bonded on the glass wafer 100. In this step of filling with resin layer 50, the space between the image sensors 40 is filled with resin, and then the resultant structure is baked to be hardened. The resin includes epoxy, Benzocyclobutene (BCB), etc.

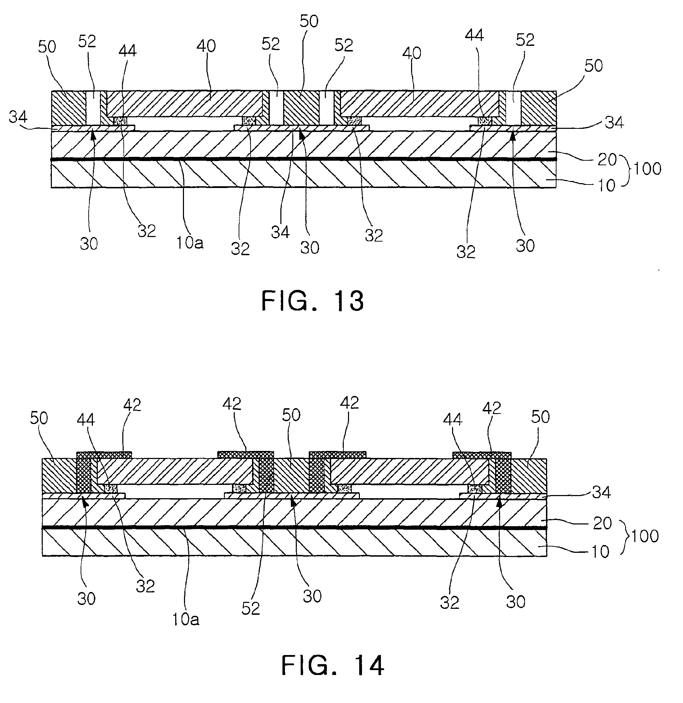

As shown in FIG. 13, the above step includes etching the vias 52 in the hardened resin. There may be several methods for etching the vias 52. For example, the vias 52 can be etched in a photolithography step using a mask, including exposure to light and development. The vias 52 can also be etched by laser or dry etching.

In addition, the above step includes coating or filling with metal inside the vias 52 formed in the hardened resin layer 50 to form redistribution pads 42 on the backside of the image sensor 40 to be electrically connected to the expansion pads 34.

As shown in FIG. 14, this step extends the expansion pads 34 to the backside of the image sensor 40 to form the redistribution pads 42. This can be conducted by forming the seed metal via PVD, Chemical Vapor Deposition (CVD) or electroless method, then by coating or filling with metal inside the vias 52 by means of PVD, electric plating, conducting material, etc. In this step of forming the redistribution pads 42, etching the resin layer 50 is easier to conduct, ensuring a better quality than etching the silicon wafer.

In addition, the fabrication method of the chip scale image sensor module according to the present invention includes providing solder balls 70 on each redistribution pad 42 of the image sensor 40.

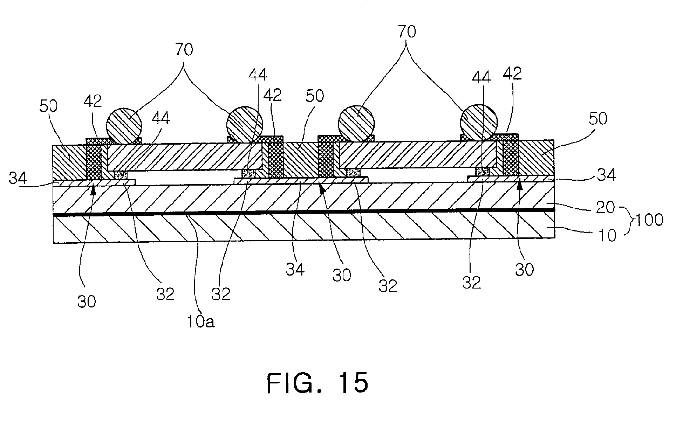

As shown in FIG. 15, this step provides solder balls 70 on the redistribution pads 42 formed in the backside of the image sensor 40. More specifically, this step can be carried out by providing solder balls 70 on the redistribution pads 42 via printing. A mask can be used if the pitch of the solder balls 70 is large or photo-resist film can be used if the pitch is minute.

In the present invention, photo-resist film is used since the pitch of the solder balls 70 is becoming smaller with the current trend of the electric devices becoming slim and light.

The above described methods for provision of solder balls 70 are not described further in details as they are in a variety, and already known widely.

Moreover, the fabrication method of the chip scale image sensor module according to the present invention includes dicing the glass wafer 100, produced by the above described steps, into a plurality of chip scale image sensor modules 1.

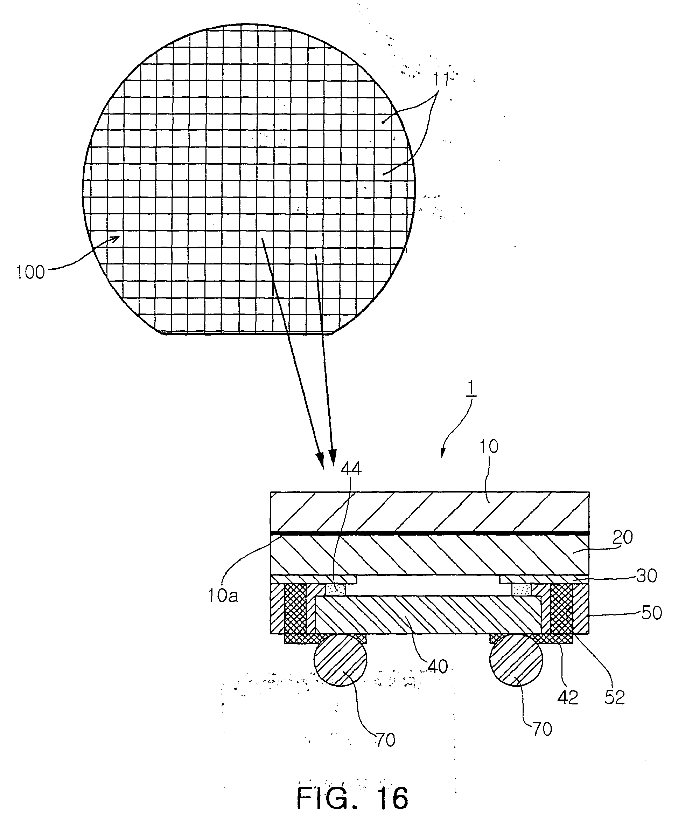

As shown in FIG. 16, this step dices the glass wafer 100, completed by the above described fabrication steps, into a plurality of individual chip scale image sensor modules 1. This step dices between the expansion pads 34 formed for each image sensor 40 to produce a plurality of good quality chip scale image sensor modules 1.

Since the separated individual chip scale image sensor modules 1 are already provided with solder balls 70 on the backside of the image sensor 40, they are easily assembled into the camera module via a general reflow process, thus omitting so many steps in the manufacturing process of the camera module.

In addition, as the chip scale image sensor module 1 according to the present invention integrally constitutes the optical filter 10 as well as the image sensor 40, preparation steps for the optical filter 10 such as individual cutting of the optical filter 10, examination after cutting, bond dispensing, attachment of the optical filter 10, and UV hardening can be omitted or eliminated, compared with the conventional fabrication method of a camera module.

The present invention as set forth above has been made to substitute flip-chip bump connection which uses wire bonding of COB, Anisotropic Conductive Film (ACF) of COF or Non-Conductive Paste (NCP). Also, unlike the conventional methods, the present invention provides a chip scale image sensor module 1 in which pad electrodes 30 of the image sensor 40 are redistributed to form the bumps for attaching the solder balls 70 thereon.

Moreover, the present invention adopts the image sensor module using a glass wafer 100, selecting only good quality image sensors 40 to flip-chip bond onto the glass wafer 100. Therefore, according to the present invention, only good quality image sensors 40 are mounted, solving the problematic manufacture of defective chip scale image sensor modules 1 due to the defective quality image sensors 40.

Furthermore, the present invention uses a glass wafer 100, with a wafer-type glass layer 20 attached to an optical filter 10, bonded with image sensors 40 and filled with resin to be completely sealed. Also, vias 52 are formed in resin to provide solder bumps. Therefore, when the chip scale image sensor module 1 of the present invention is assembled into a camera module, there is no need to attach a separate optical filter 10. Accordingly, the assembly process of the camera module can be simplified and advantageous in mass production, saving the manufacturing costs.

Moreover, the present invention minimizes the size of the chip scale image sensor 40 to considerably reduce the size of the camera module, and conducts the fabrication of chip scale image sensor module 1 at a wafer level, which is advantageous in mass production and saves the manufacturing costs.

In addition, since the present invention uses the backside of the image sensor 40, the overall size of the package is considerably reduced. Further, as the connection lid takes the form of solder balls 70, the image sensor module can be conveniently packaged into PCB via general reflow packaging techniques to constitute a slim and light camera module, without using ACF or an adhesive.

While the present invention has been shown and described in connection with the preferred embodiments, it will be apparent to those skilled in the art that modifications and variations can be made without departing from the spirit and scope of the invention as defined by the appended claims.

## Claims

1. A chip scale image sensor module used in digital devices comprising:
an optical filter removing specific wavelength from the light incident onto the image sensor;
a glass layer attached to the optical filter to protect the coating layer, with pad electrodes formed on the backside thereof;
an image sensor attached to the pad electrodes of the glass layer, with redistribution pads formed from the pad electrodes to the backside thereof; and
solder balls disposed on the backside of the image sensor, electrically connected to the pad electrodes.

2. The chip scale image sensor module according to claim 1, wherein the coating layer of the optical filter is formed to face the glass layer.

3. The chip scale image sensor module according to claim 1, wherein the pad electrodes of the glass layer comprise flip-chip pads for mounting the image sensor by flip-chip bonding, and expansion pads expanded from the flip-chip pads to the image sensor.

4. The chip scale image sensor module according to claim 1, further comprising a resin layer formed in the outer sides of the image sensor.

5. The chip scale image sensor module according to claim 4, further comprising vias in the resin layer, wherein the via is charged or plated with conductive material to electrically connect the pad electrodes with the redistribution pads.

6. A fabrication method of a chip scale image sensor module used in digital devices, the method comprising steps of:
forming a glass wafer by adhesively attaching a wafer-type glass layer to an optical filter which removes specific wavelength from the light incident onto an image sensor;
forming pad electrodes on the glass layer of the glass wafer;
bonding the pad electrodes with bump electrodes to attach a plurality of image sensors to the glass wafer;
forming redistribution pads in the backside of the image sensor connected to the pad electrodes of the glass wafer;
providing solder balls on each redistribution pad of the image sensor; and
dicing the glass wafer into a plurality of image sensor modules.

7. The fabrication method of a chip scale image sensor module according to claim 6, wherein the step of forming a glass wafer comprises adhesively attaching the wafer-type glass layer to the wafer-type optical filter using a transparent adhesive, or by conducting a fusion bonding of H and OH groups using moisture in the air.

8. The fabrication method of a chip scale image sensor module according to claim 6, wherein the step of forming pad electrodes on the glass layer of the glass wafer comprises forming flip-chip pads and expansion pads to mount the image sensor on the glass wafer, by covering the glass wafer with metal and patterning the metal.

9. The fabrication method of a chip scale image sensor module according to claim 6, wherein the step of attaching image sensors to the glass wafer comprises selectively conducting flip-chip bonding of good quality image sensors.

10. The fabrication method of a chip scale image sensor module according to claim 6, wherein the step of forming redistribution pads comprises filling with resin layers the space between the image sensors on the glass wafer with the image sensors flip-chip bonded thereon, etching vias in the resin layers, and coating or filling the inside of the via with metal to electrically connect the expansion pads with the redistribution pads.

11. The fabrication method of a chip scale image sensor module according to claim 6, wherein the solder balls are provided via printing using a photo-resist film.

12. The fabrication method of a chip scale image sensor module according to claim 6, wherein the dicing step comprises dicing between the expansion pads formed for each image sensor to produce image sensor modules.
